# EUROPÄISCHE PATENTSCHRIFT

(11) **EP 1 244 938 B1**
(45) Veröffentlichungstag und Bekanntmachung des Hinweises auf die Patenterteilung: **30.03.2005**
(21) Anmeldenummer: 00969558.6
(22) Anmeldetag: 27.10.2000
(51) Int. Cl.: G03F 7/00, H01L 21/30

(54) **VERFAHREN ZUR HERSTELLUNG VON IM NANOMETERBEREICH OBERFLÄCHENDEKORIERTEN SUBSTRATEN**
METHOD FOR THE PRODUCTION OF NANOMETER RANGE SURFACE DECORATED SUBSTRATES
PROCEDE POUR PRODUIRE DES SUBSTRATS DE L'ORDRE DU NANOMETRE, A SURFACES DECOREES

(30) Priorität: 28.10.1999 DE 19952018
(43) Veröffentlichungstag der Anmeldung: 02.10.2002
(73) Patentinhaber: Universität Ulm, 89081 Ulm (DE)
(72) Erfinder: MÖLLER, Martin, 89081 Ulm (DE); ZIEMANN, Paul, 89155 Erbach (DE); SPATZ, Joachim, D-89520 Heidenheim (DE)
(74) Vertreter: Müller-Boré & Partner Patentanwälte
(86) Internationale Anmeldenummer: PCT/EP2000/010607
(87) Internationale Veröffentlichungsnummer: WO 2001/031402

(56) Entgegenhaltungen:
- DE-A- 19 747 815
- US-A- 4 519 872
- US-A- 6 051 149
- LIU J ET AL: "MICROFABRICATION OF NANOSCALE CLUSTER CHAINS ON A PATTERNED SI SURFACE" APPLIED PHYSICS LETTERS,US,AMERICAN INSTITUTE OF PHYSICS. NEW YORK, Bd. 73, Nr. 14, 5. Oktober 1998 (1998-10-05), Seiten 2030-2032, XP000788509 ISSN: 0003-6951
- SPATZ J P ET AL: "GOLD NANOPARTICLES IN MICELLAR POLY(STYRENE)-B-POLY(ETHYLENE OXIDE)FILMS - SIZE AND INTERPARTICLE DISTANCE CONTROL IN MONOPARTICULATE FILMS" ADVANCED MATERIALS,DE,VCH VERLAGSGESELLSCHAFT, WEINHEIM, Bd. 8, Nr. 4, 1. April 1996 (1996-04-01), Seiten 337-340, XP000587111 ISSN: 0935-9648

## Beschreibung

Die vorliegende Erfindung betrifft ein Verfahren zur Herstellung von im Nanometerbereich oberflächendekorierten Substraten, insbesondere solcher, die darauf abgeschieden, aus anorganischen Nanoclustern aufgebaute, 1 bis 30 nm große Punkte bzw. 1 bis 30 nm breite Linien aufweisen. Das erfindungungsgemäße Verfahren beruht auf der Positionierung von polymeren Kern-Schale-Systemen, deren Kern mit geeigneten anorganischen Ausgangsverbindungen beladen ist, in Vertiefungen einer durch lithographische Techniken strukturierten Photolackschicht und anschließender Entfernung des polymeren Kern-Schale-Systems durch Trockenätzung, Pyrolyse, Oxidation oder Reduktion. Ferner betrifft die vorliegende Erfindung derartige im Nanometerbereich oberflächendekorierte Substrate.

Ein wichtiger Aspekt der Nanotechnologie ist die Verkleinerung von Strukturen auf Oberflächen, beispielsweise bei der Herstellung von Leiterbahnen auf einem Chip für die Daten- und Informationstechnik, bei der Erzeugung optisch aktiver Quantenpunkte in der Optoetektronik, bei der Positionierung nanometergroßer Verankerungspunkte für einzelne biologische Moleküle in der Biosensorik, wie z.B. DNA-Chips, und der Herstellung von Einzelelektronentransistoren. Kernpunkt hierbei ist die Entwicklung von Techniken, welche die Abscheidung bzw. Abtragung nanometergroßer Objekte auf ausgewählten Substraten, wie z.B. einem Si-Wafer, in gewünschter Größe und Form, d.h. in kontrollierten periodischen oder aperiodischen Strukturen, erlauben.

Der Stand der Technik beinhaltet vor allem Verfahren, die eine sogenannte Top-Down-Strukturierung erlauben, wobei die Strukturierung durch Ätz- und Aufwachsprozeße erfolgt. In der Halbleiterindustrie werden hierfür photolithographische Verfahren mit sichtbarem Licht und UV-Strahlung bzw. tiefer UV-Strahlung eingesetzt. Auch der Einsatz von Röntgenstrahlen wird vorgesehen (D. Goldhaber-Gordon et al., IEEE 1997, 85, 521). Der Einsatz immer kürzerer Lichtwellenlängen erfordert jedoch aufwendige Entwicklungen sowie kostspieligere Photolacke und Bestrahlungstechniken. Die derzeitigen Technologien erlauben es, Strukturen von größer als 90 nm zu erzeugen. Der Vorteil der Photolithographie liegt in der parallelen Erzeugung der Strukturen und erlaubt somit eine hohe Fertigungsgeschwindigkeit. Das serielle Verfahren der Elektronenstrahllithographie ermöglicht die Erzeugung noch kleinerer Strukturen (größer 10 nm), verlangt aber sehr lange und damit kostspielige Schreibzeiten. Strukturen von größer als 50 nm sind standardmäßig durch die Elektronenstrahllithographie produzierbar, wohingegen Strukturen zwischen 10 und 50 nm einen sehr hohen Aufwand erfordern.

Die vorgenannten Methoden werden auch zur Erzeugung von Stempeln, welche wiederholt zur Strukturierung von Oberflächen eingesetzt werden können, herangezogen. Die hierbei erzielten kleinsten Strukturen liegen bei ca. 10 nm (S.Y. Chou et al., Appl. Phys. Lett. 1995, 67, 3114; S.Y. Chou et al., Science 1996, 272, 85; H.A. Biebuyck et al., Lithography beyond light: microcontact printing with monolayer resists, IBM J. Res. Dev. 1997, 41(1/2), 159). Auch hier ist das Herstellen sehr kleiner Strukturen nur auf sehr kleinen Flächen möglich. Atomstrahllithographietechniken bieten aufgrund der hohen Kosten keine wirtschaftliche Alternative (D. Haubrich et al, Phys. Bl. 1997, 53, 523). Rastersondenmikroskopische Techniken (B. lrmer et al., Semicond. Sci. Technol. 1998, 13, A79; J. Cortes Rosa et al., Appl. Phys. Lett. 1998, 73, 2684) sind zwar für sehr unterschiedliche Substrate einsetzbar, jedoch ist der zeitliche Aufwand wegen der seriellen Schreibweise wiederum sehr groß. Elektrochemische Techniken (D.M. Kolb et al., Science 1997, 275, 1097) erlauben prinzipiell die Herstellung nanometergroßer Objekte, wobei nicht die Technik, sondern deren zeitlicher Aufwand und die Einschränkung bezüglich der Substrate und der Umgebung die praktische Anwendung limitieren.

Einen alternativen Ansatz bietet ein sogenannter "Bottom-Up"-Ansatz, wie in DE 197 47 815 A1 und WO 99/21652 beschrieben, wobei die Strukturen aus atomaren und molekularen. Bausteinen aufgebaut werden. Die Strukturbildung wird dabei durch Selbstorganisationsprozeße gesteuert, wobei sogenannte Templateffekte eine wichtige Rolle spielen. Darunter versteht man die Vorgabe von Hilfsstrukturen, welche das Wachstum, die Struktur und die Anordnung des darauf aufbauenden Systems kontrollieren. Solche Template sind beispielsweise Blockcopolymere und Pfropfcopolymere, die in geeigneten Lösemitteln zu mizellaren Kern-Schalesystemen assoziieren, sowie hochverzweigte dendritische Moleküle mit einer Kern-Schale Struktur. Diese Kern-Schale Strukturen dienen zur Lokalisierung anorganischer Vorstufen, aus denen anschließend nanometergroße, anorganische Teilchen mit einer kontrollierten Größe, die durch die Polymerhülle räumlich voneinander isoliert sind, abgeschieden werden können. Die Kern-Schale-Systeme oder Mizellen können dabei durch einfache Abscheidungsvorgänge wie Spin-Casting oder Dip-Coating als hochgeordnete Monofilme auf unterschiedliche Substrate aufgebracht werden. Die organische Matrix kann anschließend durch einen Gas-Plasma-Prozeß oder durch Pyrolyse rückstandsfrei entfernt werden, wobei die Nanopartikel in der Ordnung auf dem Substrat fixiert werden, in der sie durch das organische Templat positioniert wurden. Die Größe der Nanopartikel wird dabei durch die Einwaage einer bestimmten anorganischen Precursorverbindung und der laterale Abstand zwischen den Nanopartikeln durch die Struktur, insbesondere durch das Molekulargewicht der organischen Matrix, bestimmt. Hierbei können Teilchengrößen im Bereich von 1 und 30 nm von Au-, Ag-, Pt-, Pd-, Ni-, Co-, Fe- und Ti-Teilchen sowie deren Oxide und Legierungen in Mustern auf Substraten abgeschieden werden, wobei die Muster eine Periodizität von bis zu 400 nm aufweisen. Dieses Verfahren erlaubt somit die einfache Erzeugung und Positionierung nanometergroßer Objekte.

Allerdings ist die vorgenannte Methode auf periodische Strukturen begrenzt, welche maximale Periodizitäten von ca. 400 nm erreichen können. Hierbei entspricht die Periodizität dem Durchmesser eines sphärischen Kern-Schale-Systems.

Hinsichtlich einer geometrischen Verkleinerung von Dateninformationssystemen, eines schnelleren Datenaustausches und einer Reduzierung der entstehenden Prozeßwärme, d.h. einer Erhöhung der Effektivität, ist im Bereich der Nanotechnologie jedoch eine Vergrößerung des Aspektverhältnisses von Punktmustern, die erhalten werden, wenn ein Substrat mit solchen Nanopartikeln dekoriert wird, erwünscht. Das Aspektverhältnis beschreibt dabei das Verhältnis [Separationslänge der Punkte/Punktdurchmesser]. Die Punktdurchmesser sollen dabei im Extremfall so klein werden, daß nur noch einzelne Moleküle an diese Punkte gebunden werden können, d.h. 1 bis 20 nm. Die Anzahl der bindendenden Moleküle wird durch die Punktfläche kontrolliert. Gleichzeitig sind jedoch auch große Abstände zwischen den einzelnen Punkte notwendig, um die Punkte einzeln optisch zu erfassen oder auch elektrisch kontaktieren zu können. In beiden Fällen werden dabei Separationslängen zwischen den Punkten von größer als 300 nm verlangt.

Eine weitere wichtige Zielrichtung im Bereich der Nanotechnologie ist die Verkleinerung der Breite von Leitfähigkeitspfaden und somit der Erhöhung der Leitfähigkeitspfaddichte auf Substraten. Beispielsweise dienen Leitfähigkeitspfade in Computerchips zum Austausch von Dateninformationen. Leitfähigkeitspfade im Subnanometerbereich führen zu einer geometrischen Verkleinerung von Dateninformationssystemen, einem schnelleren Datenaustausch und einer Reduzierung der entstehenden Prozeßwärme, d.h. einer Erhöhung der Effektivität.

Somit liegt der vorliegenden Erfindung die Aufgabe zugrunde, ein auf Grundlagen der organischen bzw. makromolekularen Chemie basierendes, vielseitig einsetzbares, ökonomisches Verfahren zu entwickeln, das eine derartige Strukturierung von Substraten im Nanometerbereich ermöglichen soll, daß die auf dem Substrat abgeschiedenen Nanopartikel Punktdurchmesser von 1 bis 20 nm aufweisen, gleichzeitig aber auch Separationslängen von solchen Nanopartikeln, die eine Linie aufbauen, von größer als 300 nm erreicht werden. Die durch ein solches Verfahren erhältlichen Substrate sollen dabei hinsichtlich der darauf abgeschiedenen Punktmuster, d.h. hinsichtlich der Durchmesser der Punkte im Verhältnis zum maximalen Abstand in dem Muster, ein Aspektverhältnis von größer als 50 aufweisen. Das Verfahren soll ferner die Anordnung der Punkte (Nanopartikel) in vorgegebenen aperiodischen Mustern und deren Verbindung zu nanometerschmalen Linien ermöglichen. Die erzeugten Strukturen sollen in wäßrigen und organischen Medien stabil sein und auch Temperaturen bis zum Schmelzpunkt des tragenden Substrats oder der Punkte überstehen.

Diese Aufgabe wird durch die in den Ansprüchen gekennzeichneten Ausführungsformen gelöst.

Inbesondere wird gemäß der vorliegenden Erfindung ein Verfahren zur Herstellung von im Nanometerbereich oberflächendekorierten Substraten bereitgestellt, umfassend die Schritte:
(a) Aufbringen mindestens einer Photolackschicht mit einer vorbestimmten Tiefenstruktur auf mindestens eine Oberfläche des Substrats,
(b) Aufbringen eines durch Aufnehmen eines Polymers in einem geeigneten Lösungsmittel unter Bildung eines gelösten Kern-Schale-Polymersystems und Beladen von mindestens einem Teil der Polymerkerne mit einer oder mehreren, gleichen oder unterschiedlichen Metallverbindungen hergestellten Kern-Schale-Polymersystems auf das in Schritt (a) erhaltene Substrat, so daß die vorbestimmte Tiefenstruktur des Photolacks und/oder die durch die Photolackstruktur begrenzte Substratoberfläche benetzt werden,
(c) Entfernen der Photolackschicht von der Substratoberfläche und
(d) Entfernen des das Kern-Schale-Polymersystem aufbauenden Polymers unter Erzeugung von Metaltclustern und/oder Clustern von Metallverbindungen auf der Substratoberfläche in Abhängigkeit von der in Schritt (a) vorbestimmten Tiefenstruktur.

In Schritt (a) des erfindungsgemäßen Verfahrens wird auf das Substrat eine Photolackschicht mit einer vorbestimmten Tiefenstruktur auf das Substrat aufgebracht, d.h das Substrat wird mittels eines Photolacks mit einer geeigneten Vorstruktur bzw. einer vorbestimmten Struktur mit Vertiefungen (Tiefenstruktur), belegt. Verwendbare Substrate sind vorzugsweise Edelmetalle, oxidische Gläser, mono- oder multikristalline Substrate, Halbleiter, Metalle mit oder ohne passivierter Oberfläche, Isolatoren oder allgemein Substrate mit hoher Resistenz gegen die nachfolgenden Ätzprozeduren. Insbesondere handelt es sich hierbei um Pt, Au, GaAs, In_{y}GaAs, AlₓGaAs, Si, SiO₂, Ge, SiₓN_{y}, SiₓGaAs, InP, inPSi, GaInAsP, Glas, Graphit, Diamant, Glimmer, SrTiO₃ sowie deren dotierte Modifikationen. Die verwendbaren Substrate können sowohl planare, ebene Substrate als auch solche mit planaren, gekrümmten (konvex oder konkav) Oberflächen sein. Als Photolacke können die im Stand der Technik bekannten, im Handel erhältlichen Photolacke, z.B. ein Positiv Elektron-Beam Photolack X-AR-P 7400/8 der Firma Allresist, eingesetzt werden. Ein glattes Substrat kann z. B. durch Spin-Coating mit einem Photolack beschichtet werden. Die Dicke des Films kann dabei zwischen 10 nm und mehreren µm betragen. Vorzugsweise wird der Photolack durch eine Maske hindurch mit sichtbarem Licht, UV-Strahlung oder Röntgenstrahlung bestrahlt. Alternativ kann der Photolack auch mittels Elektronenstrahlung in den gewünschten Strukturen belichtet werden. Der Photolack wird anschließend entwickelt, d.h. es wird entweder der belichtete Teil aus dem Film herausgelöst (positiver Photolack) oder der unbelichtete Photolack wird aus dem Film herausgelöst (negativer Photolack). Die eingeschriebenen Muster und Strukturen stellen Vertiefungen in dem Photolack mit einer Tiefe dar, welche der Photolackschichtdicke entspricht. Hierbei können die Strukturen periodisch oder aperiodisch sein. Die Vertiefungen können beispielsweise eine Länge und eine Breite zwischen 15 nm und mehreren µm und eine Tiefe zwischen 5 nm und mehreren Mikrometern aufweisen. insbesondere können Vorstrukturen gebildet werden, die größer als 40 nm sind. Eine Vorstruktur kann beispielsweise auch durch nur eine Wand des Photolackfilms, d.h. im Sinne einer Stufe, gebildet werden.

In Schritt (b) des erfindungsgemäßen Verfahrens wird das in Schritt (a) derart vorstrukturierte Substrat mit den in der Phototackschicht beschriebenen Vertiefungen mit eine Lösung polymerer Kern-Schale-Teilchen benetzt, deren Kernvolumen ein oder mehrere, gleiche oder unterschiedliche Metallverbindungen (d.h. eine anorganische Vorstufenverbindung oder ein anorganisches Nanoteilchen) beinhaltet.

Unter dem Ausdruck "Kern-Schale-Polymersystem", wie hier verwendet, sind beispielsweise makromolekulare Amphiphile zu verstehen, welche in wäßriger oder organischer Lösung assoziieren und wohldefinierte kugelförmige bzw. stäbchenförmige Mizellen, Lamellen, Vesikel oder komplexe Aggregate bilden können. Erfindungsgemäß sind damit auch solche, allgemein als Wirt/Gast-Systeme bezeichnete Systeme eingeschlossen, in denen ein von dem eingesetzten Polymer (Wirtsverbindung) erzeugter Molekülhohlraum bzw. Molekülinnenraum, d.h. der Polymerkern, mit einer Gastverbindung, d.h. der verwendeten Metallverbindung, beladen bzw. komplexiert werden kann.

Das in dem Verfahren erfindungsgemäß eingesetzte Polymer, welches in Lösung ein solches Kern-Schale-Polymersystem aufbaut, ist vorzugsweise aus Blockcopolymeren, Pfropfcopolymeren, Miktoarmsternpolymeren, Sternpolymeren mit unterschiedlichen Armen, dentritischen Polymeren, Mikrogelteifchen, Sternblockpolymeren, Blocksternpolymeren und Kern-Schale-Latexpolymeren ausgewählt.

Mehr bevorzugt ist das Polymer Polystyrol-b-polyethytenoxid, Polystyrol-bpoly(2-vinylpyridin), Potystyrol-b-poly(4-vinylpyridin) oder ein Gemisch davon. Der Polystyrolblock darin kann aber auch durch andere nicht-polare Polymere, wie beispielsweise Polyisopren, Polybutadien, Polymethylmethacrylat oder andere Polymethacrylate ersetzt werden. Der zweite bzw. polare Block in einem solchen Zweiblockcopolymer kann ein solcher sein, der eine möglichst starke Wechselwirkung mit der eingesetzten Metallverbindung eingeht. Beispiele hierfür sind Polyacrylsäure, Polymethacrylsäure, aminosubstituierte Polystyrole, Polyacrylate bzw. Polymethacrylate, aminosubstituierte Polydiene, Polyethylenimine, verseifte Polyoxazoline oder hydriertes Polyacrylnitril. Der erste Block kann auch aus einem polaren Polymer aufgebaut sein, jedoch mit der Maßgabe, daß dann die Metallverbindung derart gewählt ist, daß diese hauptsächlich, d.h. selektiv, mit dem zweiten polaren Block wechselwirkt.

Typischerweise werden die vorgenannten Polymersysteme in einem selektiven Lösungsmittel, wie z.B Toluol, in einer Menge von etwa 10⁻³ bis etwa 100 mg/ml, vorzugsweise etwa 5 mg/ml, gelöst. Das Lösungsmittel für die polymeren Kern-Schale Teilchen bzw. der strukturierte Photolack muß dabei so gewählt werden, daß der strukturierte Photolack während des Benetzungsschritts nicht abgelöst wird.

Die erfindungsgemäß eingesetzten Metallverbindungen sind beispielsweise Verbindungen von Au, Pt, Pd, Ag, In, Fe, Zr, Al, Co, Ni, Ga, Sn, Zn, Ti, Si und Ge in den entsprechenden Oxidationsstufen oder Gemische davon. Spezifische Beispiele sind HAuCl₄, MeAuCl₄, wobei Me ein Alkalimetall bedeutet, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, wobei R einen geradkettigen oder verzweigtkettigen C₁-C₈-Alkylrest bedeutet, Ferrocen, Zeisesalz und SnBu₃H oder Gemische davon. Vorzugsweise ist die Metallverbindung HAuCl₄. Typische Einwaagen sind 0,01 bis 2,0 Mol an Vorstufenverbindung pro Monomerverbindung des polaren Polymerblocks.

Das Aufbringen auf mindestens eine Seite des in Schritt (a) erhaltenen, vorstrukturierten Substrats kann beispielsweise durch Tauch-, Gieß-, Spinschleuderverfahren oder durch Adsorption aus verdünnter Lösung durchgeführt werden. Mehr bevorzugt wird das Aufbringen durch Spinschleuderverfahren in verdünnter Lösung durchgeführt. Die mit der Metallverbindung und/oder den Metallteilchen beladenen Polymerkerne, d.h. beispielsweise die Mizellen oder entsprechende Molekülhohlräume, werden dabei im wesentlichen intakt abgeschieden.

Das Aufbringen des Kern-Schale-Polymersystems in Schritt (b) des erfindungsgemäßen Verfahrens hat die Wirkung, daß die vorbestimmte Tiefenstruktur des Photolacks und/oder die durch die Photolackstruktur begrenzte Substratoberfläche benetzt werden. Überraschenderweise wurde festgestellt, daß die während des Verdampfens in dem dünner werdenden Flüssigkeitsfilm auftretenden Kapillarkräfte zwischen den gelösten Teilchen und den Stufen und in den Vertiefungen eine sehr genaue Positionierung der Kern-Schale-Teilchen entlang der Stufen und in den Vertiefungen erlauben. Je nach Wahl des Lösungsmittels und der Grenzflächenenergie der beteiligten Komponenten (Kern-Schale-Teilchen, Photolack, Substrat, Lösung) kann die Lösung entweder den Photolack benetzen oder entnetzen. Das mit einer anorganischen Vorstufen verbindung oder einem anorganischen Nanoobjekt beladene Kernvolumen wird somit aufgrund der Kapillareffekte entweder im Zentrum der Vertiefung oder in einem Abstand von einer Photolackwand positioniert, welcher dem Ausmaß der Schale des Kern-Schale-Systems entspricht. Die Positionierung der Kern-Schale- Teilchen kann gemäß der vorliegenden Erfindung besonders genau erreicht werden, wenn die Abmessungen (Breite und Länge) der Vertiefungen in der Photolackschicht den Abmessungen der Kern-Schale Teilchen entsprechen. Über die Dicke der Photolackbeschichtung kann die Tiefe der Vertiefung eingestellt werden. In Vertiefungen oder Löchern großer Tiefe können mehrere Kern-Schale Teilchen übereinander gestapelt werden. Hierdurch ergibt sich die Möglichkeit, die Anzahl der Kern-Schale-Teilchen und damit die Menge des anorganischen Materials, welches mit Hilfe der Teilchen an einer bestimmten Stelle der Oberfläche positioniert wird, einzustellen.

In Schritt (c) des erfindungsgemäßen Verfahrens wird der Photolack von der Substratoberfläche entfernt. Vorzugsweise wird der Photolack von der Substratoberfläche mit Hilfe eines Lösemittels abgelöst. Analog einem Lift-Off-Prozeß werden dabei auch alle Kern-Schale-Teilchen mitentfernt, die auf der Lackoberfläche und nicht auf dem in den Vertiefungen freigelegtem Substrat abgeschieden wurden. Die in den Vertiefungen lokalisierten Kern-Schale-Systeme bleiben von dem Lösungsprozeß unberührt, da diese Kern-Schale-Systeme in Kontakt mit der zu strukturierenden Substratoberfläche stehen und in dem verwendeten Lösemittel nahezu unlöslich sind.

In Schritt (d) des erfindungsgemäßen Verfahrens wird die organische Hülle des Kern-Schale Systems rückstandsfrei entfernt, beispielsweise durch eine Trockenätzung, Pyrolyse, Oxidation oder Reduktion. Dabei wird die ursprünglich in den Kern-Schale Teilchen enthaltene anorganische Komponente freigelegt und in der Form nanometergroßer Cluster (Punkte) abgeschieden. Dabei wird das die Schale bildende Polymer des Kern-Schale-Polymersystems unter Erzeugung von Metallclustern und/oder Clustern von Metallverbindungen auf der Substratoberfläche vollständig entfernt, ohne daß die in Abhängigkeit von der in Schritt (a) vorbestimmten Tiefenstruktur durch das Kern-Schale-Polymersystem aufgebaute Struktur geändert wird. Die Nanopartikel werden dadurch in der Ordnung auf dem Substrat fixiert, wie sie durch die lithographisch erzeugte Vorstrukturierung vorgegeben wurde. Wie oben ausgeführt, wird das Polymer in Schritt (d) beispielsweise mittels eines Pyrolyse-, Ätz-, Reduktions- oder Oxidationsprozesses entfernt. Die vorgenannten Prozesse können auch bei erhöhter Temperatur durchgeführt werden. Insbesondere wird die Ätzbehandlung mittels eines reaktiven Plasmas, vorzugsweise ein Sauerstoffplasma, durchgeführt. Reaktive Gas-Plasma-Verfahren (CF₄, H₂, SFₓ) oder die Oxidation in einer oxidierenden Atmosphäre bei einer erhöhten Temperatur, die Ätzung durch energiereiche Strahlung, insbesondere durch elektromagnetische Strahlen oder Teilchenstrahlen wie Elektronenstrahlen, können ebenfalls zur Entfernung der Polymerhülle eingesetzt werden.

Durch die vorgenannten Techniken in Schritt (d) des erfindungsgemäßen Verfahrens wird die organische Polymerhülle an der gewünschten Stelle bzw. an dem gewünschten Bereich rückstandsfrei entfernt. Sofern metallische Vorstufen, d.h. anorganische Precursorverbindungen, in den Kern-Schale-Polymersystemen vorlagen, werden diese in ihre kristalline Me bzw. MeOₓ -Modifikation in Form von Agglomerationen von kleinen Me- bzw. MeOₓ-Teilchen, sogenannten Nanoclustern, überführt.

In einer anderen Ausführungsform der vorliegenden Erfindung können der Photolack und die organische Polymerhülle des Kern-Schale-Polymersystemen mittels Trockenätzung, Pyrolyse, Oxidation oder Reduktion gleichzeitig entfernt werden, d.h. daß die Schritte (c) und (d) des erfindungsgemäßen Verfahrens nicht nacheinander, sondern kombiniert bzw. gleichzeitig durchgeführt werden. In diesem Fall kommt es zu einer Abscheidung von anorganischen Nanopartikeln in den Bereichen der Photolackvertiefung und in den nicht-strukturierten Bereichen, wobei aber die Randgebiete um die in den Photolack eingeschriebenen Strukturen von der Belegung durch die anorganischen Cluster frei bleiben. Aufgrund der Kapillarkräfte werden die Kern-Schale-Teilchen in dem vorstehenden Schritt (b) des erfindungsgemäßen Verfahrens aus diesem Randbereich in die Vertiefung "gezogen". Die geometrische Abmessung des nicht belegten Bereichs, d.h. frei von anorganischen Nanopartikeln, wird dabei durch die Wirkungslänge der Kapillarkräfte bestimmt. Diese Wirkungslänge kann mehrere µm betragen.

Die abgeschiedenen Cluster sind, abhängig von den in Schritt (b) eingesetzten Metallverbindungen, insbesondere sauerstoffresistente Edelmetalle, wie Au, Pt, Pd, oder Oxide, z.B. halbleitende Oxide wie TiO₂, oder magnetische Teilchen, wie z.B. bestimmte Modifikationen von Fe₂O₃, Fe, Co oder Ni.

In vorteilhafter Weise kann durch das erfindungsgemäße Verfahren die Größe der einzelnen Nanocluster durch die Größe und Beladung des Kernvolumens der polymeren Kern-Schale-Teilchen bestimmt werden. Der Abstand zwischen Nanoclustern, welche längs einer, in den Photolack geschriebenen Struktur abgelegt werden, wird durch die Dicke der Schale der polymeren Kern-Schale-Teilchen beschrieben. Die Einstellung der Größe sphärischer Nanoobjekte ergibt sich, wie vorstehend ausgeführt, durch die entsprechende Wahl des mit einer oder mehreren, gleichen oder unterschiedlichen Metallverbindungen hergestellten Kern-Schale-Polymersystems. Darüberhinaus kann die Belegung eines bestimmten Punktes der Oberfläche durch mehrere Cluster, wie oben beschrieben, durch die Tiefe der Vertiefungen eingestellt werden.

Ferner können in vorteilhafter Weise durch das erfindungsgemäße Verfahren nanometergroße Linien durch das Aneinanderreihen von anorganischen Clustern erzeugt werden. Die Aneinanderreihung kann entweder bereits in der Lösung der polymeren Kern-Schale-Teilchen oder während der Entfernung der Kern-Schale-Matrix erfolgen. Beispielsweise können im Falle der Aneinanderreihung in Lösung durch Koagulation sphärischer Mizellen zylindrische Mizellen gebildet werden, die mit einer anorganischen Komponente beladen sind. Hierbei können dann mehrere Kern-Schale-Teilchen in einer Vertiefung übereinandergestapelt werden. Die Stapelhöhe hängt dabei von der strukturierten Photolackschichtdicke und den Abscheidungsbedingungen, wie z.B. der Konzentration der Lösung, ab.

Die durch das erfindungsgemäße Verfahren erhältlichen Muster bzw. Strukturen bzw. oberflächendekorierte Substrate sind zur Herstellung chemischer Sensoren verwendbar, wobei die Punkte bzw. Nanopartikel als Ankerpunkte für chemische Rezeptoren eingesetzt werden können und aufgrund der reduzierten Dimension der Punkte eine höhere Sensititvität zu erwarten ist. Darüberhinaus sind die erfindungsgemäßen oberflächendekorierten Substrate zum Aufbau eines Einzelelektronentransistors, welcher bei Temperaturen von größer als 77 K seine Funktion behält, einsetzbar, wobei ein Substrat flächendeckend in hoher Dichte mit solchen Transistoren bestückt werden kann.

Durch das erfindungsgemäße Verfahren können auf entsprechenden Substraten abgeschiedene Strukturen in Form von Leitfähigkeitspfaden im Subnanometerbereich erhalten werden, die eine geometrische Verkleinerung von Dateninformationssystemen, einen schnelleren Datenaustausch und eine Reduzierung der entstehenden Prozeßwärme, d.h. eine Erhöhung der Effektivität, gestatten. Die Kombination zweier unterschiedlicher Metalle, beispielsweise durch das Kreuzen zweier Nanolinien aus Pt und Ir, ermöglicht in einfacher Weise die Herstellung einer thermischen Nanosonde zur Detektion lokaler Temperaturveränderungen im Subnanometerbereich.

Ein weiterer Gegenstand der vorliegenden Erfindung sind im Nanometerbereich oberflächendekorierte Substrate, welche auf mindestens einer Oberfläche Strukturen aus 1 bis 30 nm großen und/oder 1 bis 30 nm breiten Linien aufweisen, die aus Clustern von Metallatomen und/oder Metallverbindungen aufgebaut sind, die ein Aspektverhältnis von größer als 50 aufweisen. Die Separationslängen zwischen den einzelnen Clustern, welche eine Linie aufbauen, können mehr als 300 nm betragen, wobei die Separationsiänge im wesentlichen durch das Kern-Schale-System bestimmt wird. Die Cluster können aus gleichen oder unterschiedlichen Metallatomen und/oder Metalloxiden bestehen. Die Nanocluster können insbesondere Gold-, Platin-, Palladium-, Titandioxid-, Eisenoxid- und Cobaltoxidcluster, mehr bevorzugt Goldnanocluster, sein. Die erfindungsgemäßen oberflächendekorierten Substrate können auch Cluster aus beispielsweise Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Graphit oder Pt/Al₂O₃ aufweisen. Bevorzugte Substrate sind Pt, Au, GaAs, In_{y}GaAs, AlₓGaAs, Si, SiO₂, Ge, SiₓN_{y}, SiₓGaAs, InP, InPSi, GalnAsP, Glas, Graphit, Diamant, Glimmer, SrTiO₃ oder deren dotierte Modifikationen. Diese durch das erfindungsgemäße Verfahren erhältlichen, mit anorganischen Nanocfuster im Nanometerbereich oberflächendekorierten Substrate, d.h. die Nanoteilchen auf dem Substrat zeichnen sich neben ihrer hohen Einheitlichkeit auch durch ihre hohe Temperaturbeständigkeit aus.

Ein weiterer Gegenstand der vorliegenden Erfindung ist die Verwendung der im Nanometerbereich oberflächendekorierten Substrate als Master zur Erzeugung eines Stempels, welcher für den weiteren Übertrag der Nanostrukturen eingesetzt werden kann, als Maske zum Übertrag in ein unterliegendes Substrat oder einen Film durch Trocken- oder Naßätzprozesse, als Ausgangspunkte für die Verankerung weitererer Moleküle, wie biologische Moleküle (z.B. DNA- und DNA-ähnliche Moleküle), Cluster und Atome an die einzelnen Nanocluster, als Streuzentren von elektromagnetischen Wellen und zur Modulierung von Brechungsindices, Leitfähigkeits- und Magnetismuseigenschaften von Substraten.

Die abgeschiedenen anorganischen Elemente können darüberhinaus auch als Maske zum Übertrag der Maskenstruktur in ein unterliegendes Substrat durch beispielsweise Reaktives Ionenätzen (RIE) oder tonen-Abtrag dienen. Dadurch können subnanometergroße Punkte oder subnanometerbreite Linien z.B. in eine optisch aktive Halbleiterschichtstruktur übertragen werden. Die Strukturierung von oder durch magnetische Materie im Subnanometerbereich erhöht dabei die mögliche Datenspeicherdichte.

Die Figuren (Abbildungen) zeigen:
Fig. 1 ist eine schematische Darstellung und eine rasterkraftmikroskopische Aufnahme des in Beispiel 1 erhaltenen trockenen Films.
Fig. 2 ist eine rasterkraftmikroskopische Aufnahme der in Beispiel 1 erhaltenen Goldnanocluster auf SrTiO₃ nach Behandlung in einer Sauerstoffatmosphäre.
Fig. 3 ist eine rasterkraftmikroskopische Aufnahme der in Beispiel 2 erhaltenen Goldnanocluster auf SrTiO₃ nach Behandlung in einer Sauerstoffatmosphäre.
Fig. 4 ist eine rasterkraftmikroskopische Aufnahme des in Beispiel 3 erhaltenen Substrats, wobei die schwarze Linie die Wirkungslänge der Kapillarkräfte zeigt.
Fig. 5 ist eine rasterkraftmikroskopische Aufnahme der in Beispiel 3 erhaltenen Goldnanocluster auf SrTiO₃ nach Behandlung in einer Sauerstoffatmosphäre. Die Figur zeigt eine ca. 10 nm breite und 100 µm lange Goldlinie, welche aus einzelnen Clustern aufgebaut ist.
Figur 6 ist eine rasterkraftmikroskopische Aufnahme einer 20 nm breiten und 50 nm hohen, aus einzelnen Goldclustern aufgebauten Linie auf dem in Beispiel 4 erhaltenen Substrat.
Fig. 7 ist eine rasterkraftmikroskopische Aufnahme 10 nm breiter und 100 µm langer, aus einzelnen Goldclustern aufgebauten Linien in unterschiedlichen Abständen zueinander auf dem in Beispiel 5 erhaltenen Substrat.
Fig. 8 ist eine rasterkraftmikroskopische Aufnahme 10 nm breiter und 100 µm langer, aus einzelnen Goldclustern aufgebauter Linien in unterschiedlichen Abständen zueinander und Quadrate mit einem Rahmen von 10 nm breiten Linien auf dem in Beispiel 6 erhaltenen Substrat.

Die vorliegende Erfindung wird nachstehend durch Beispiele näher erläutert.

### Beispiel 1

Ein Positiv Elektron-Beam Photolack X-AR-P 7400/8 der Firma Allresist wurde durch Spin-Casting (2000 rpm) mit einer Schichtdicke von ca. 600 nm auf ein SrTiO₃ Substrat aufgebracht. Der Film wurde durch Elektronenstrahllithographie belichtet, so daß nach der Entwicklung des Photolacks ca. 200 nm breite, 600 nm tiefe Gräben verblieben. Diese Strukturen wurden durch Spin-Casting (10000 rpm) einer mizellaren Poly(styrol(1700))-block-Poly([2-vinylpyridin•(HAuCl₄)_{0.5}](450))-Toluollösung (c = 0,1 g/l), wobei die Zahlen in den Klammern die Anzahl der Monomereinheiten des jeweiligen Polymerblocks angeben, benetzt.

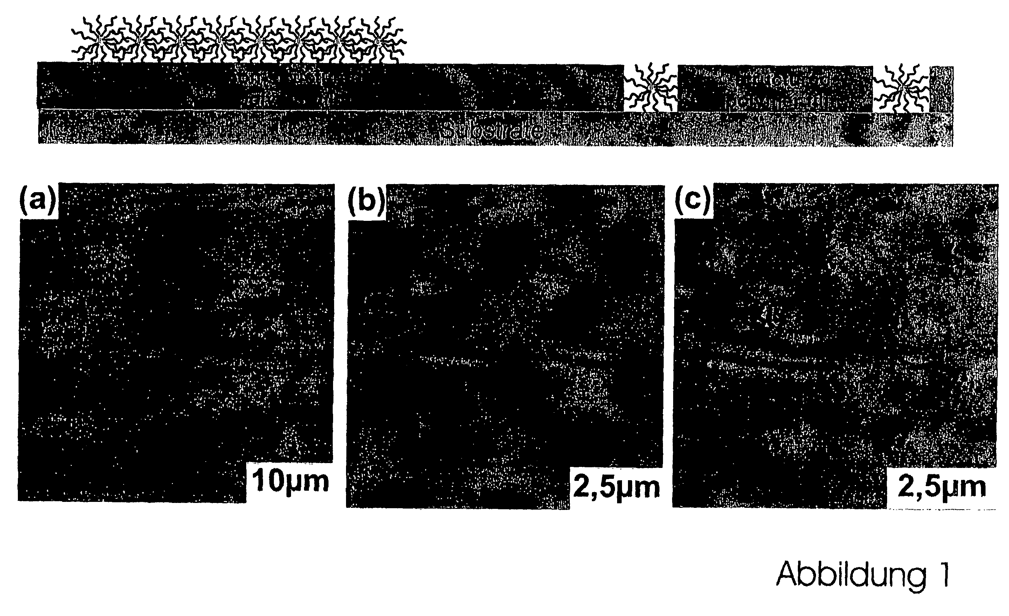

Figur 1 zeigt eine schematische Darstellung und eine rasterkraftmikroskopische Aufnahme des trockenen Films. Der nicht strukturierte Bereich des Photolacks ist durch gelbe Punkte markiert, welche Kern-Schale-Mizellen darstellen. Der strukturierte Bereich zeigt keine Mizellen auf den Stegen, aber in den Löchern.

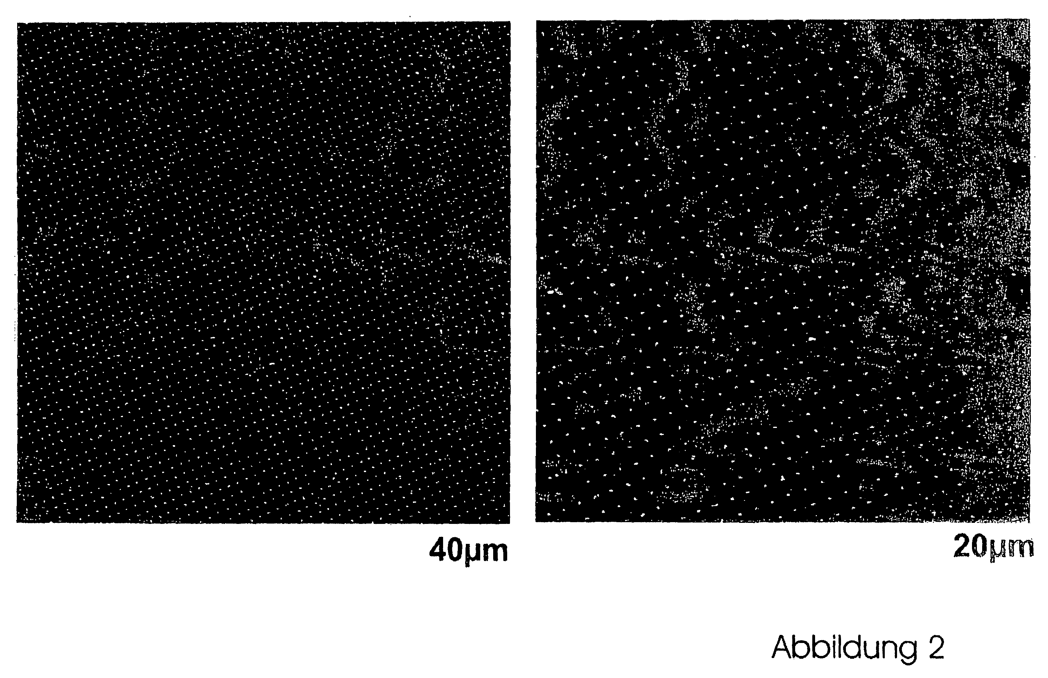

Der Photolack wurde durch Aceton aufgelöst und das verbleibende System anschließend in einem Sauerstoff-Plasma (100 W, 1 mbar, 10 min.) behandelt. Es verblieben 30 nm große Goldpunkte auf SrTiO₃ in dem Muster (kubisch, 800 nm Separation der Nanoclustern), welches die Elektronenstrahllithographie in den Photolack eingeprägt hatte (Figur 2), wobei jeder Goldpunkt aus dem Inhalt von mindestens 8 Poly(styrol(1700))-block-Poly([2-vinylpyridin•(HAuCl₄)_{0.5}](450)) Mizellen besteht, die während des Abscheideprozesses der mizellaren Lösung in den Vertiefungen des Photolacks übereinandergestapelt wurden.

### Beispiel 2

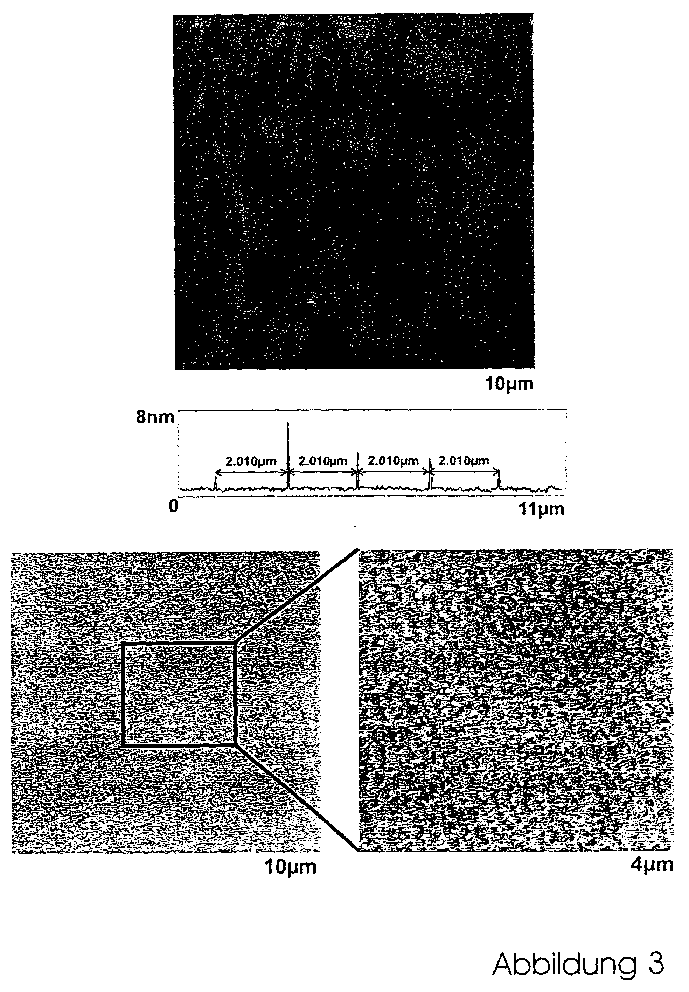

Ein Positiv Elektron-Beam Photolack X-AR-P 7400/8 der Firma Allresist wurde durch Spin-Casting (2000 rpm) mit einer Schichtdicke von ca. 75 nm auf ein SrTiO₃ Substrat aufgebracht. Der Film wurde durch Elektronenstrahllithographie derart belichtet, daß nach der Entwicklung des Photolacks ca. 200 nm breite, 75 nm tiefe Gräben verblieben. Diese Strukturen werden durch Spin-Casting (10000 rpm) einer mizellaren Poly(styrol(1700))-block-Poly([2-vinylpyridin•(HAuCl₄)_{0.5}](450)) Toluollösung (c=0,1 g/l), wobei die Zahlen in den Klammern die Anzahl der Monomereinheiten des jeweiligen Polymerblocks angeben, benetzt. Der Photolack wurde durch Aceton aufgelöst und das verbleibende System anschließend in einem Sauerstoff-Plasma (100 W, 1 mbar, 10 min.) behandelt. Es verblieben einzelne 8 nm große Goldpunkte auf SrTiO₃ in dem Muster (kubisch, 2µm Separation der einzelnen Nanocluster), weiches die Elektronenstrahllithographie in den Photolack eingeprägt hatte (Figur 3). Hierbei entsprach das Volumen der Vertiefungen jeweils dem einer eingesetzten Poly(styrol(1700))-block-Poly([2-vinylpyridin•(HAuCl₄)_{0.5}](450))-Zweiblockcopolymermizelle.

### Beispiel 3

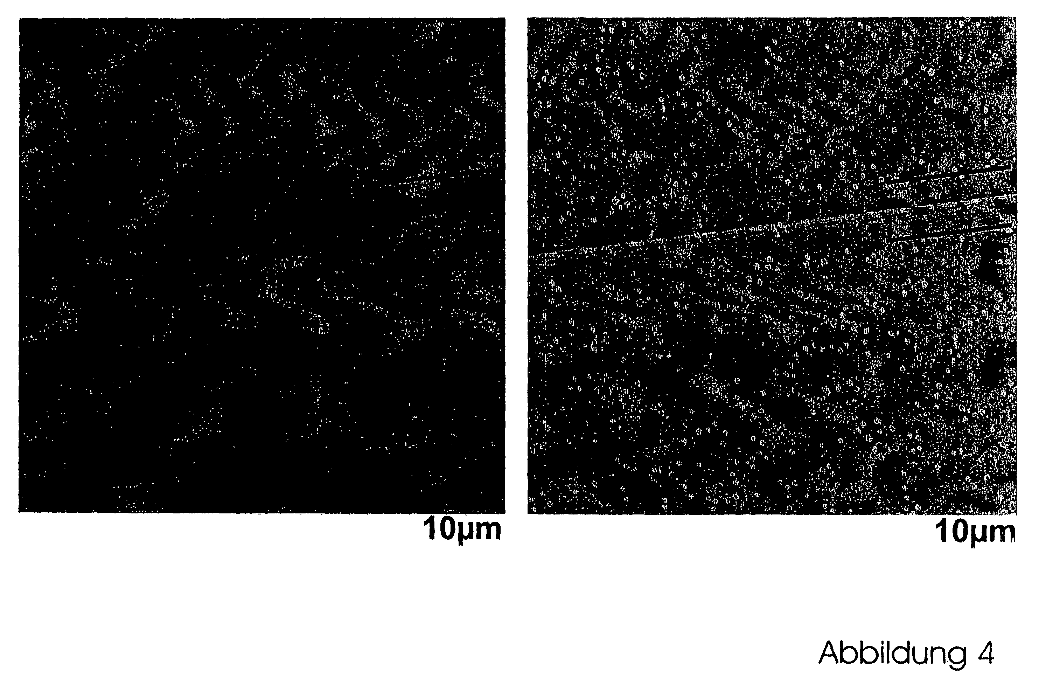

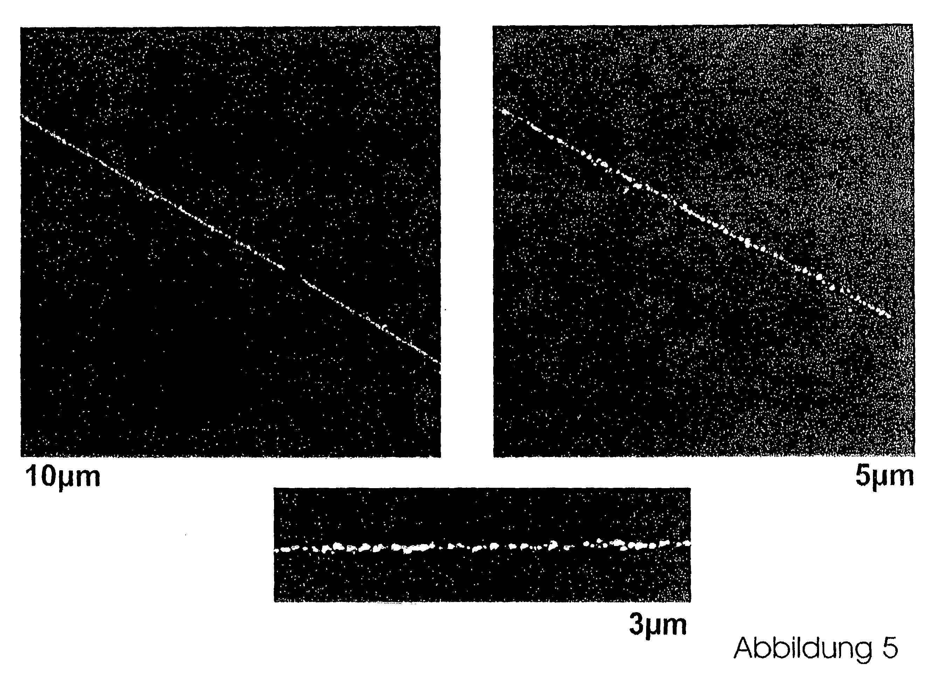

Eine gemäß Beispiel 1 beschriebene Photolackschicht wurde mit Linien strukturiert. Nach dem Entwickeln des Films verblieb eine ca. 200 nm breite, 600 nm tiefe und 100 µm lange Linie. Das System wurde mit der im vorstehenden Beispiel 1 beschriebenen Lösung entsprechend behandelt. Figur 4 zeigt eine entsprechende rasterkraftmikroskopische Aufnahme. Die schwarze Linie zeigt die Wirkungslänge der Kapillarkräfte, welche die Mizellen in dem Graben positionieren. Figur 5 zeigt eine rasterkraftmikroskopische Aufnahme nach der Behandlung des Systems mit Aceton und anschließend in einem Sauerstoffplasma analog Beispiel 1. Die Figur 5 zeigt dabei eine ca. 10 nm breite und 100 µm lange Goldlinie, welche aus einzelnen Clustern aufgebaut ist.

### Beispiel 4

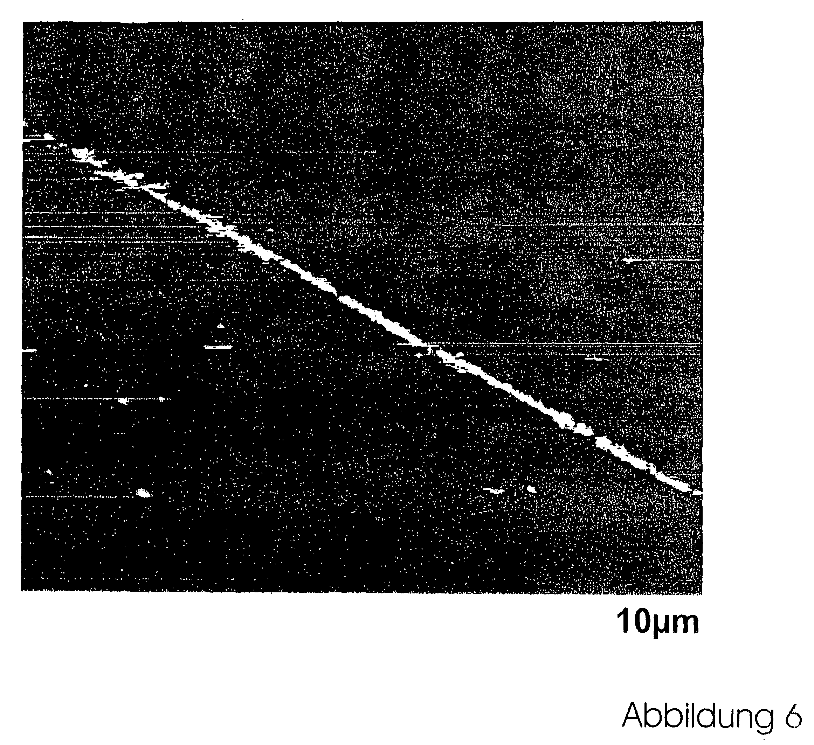

Es wurde gemäß Beispiel 3 vorgegangen, mit der Ausnahme, daß eine 2,5 g/l mizellare Lösung mit 5000 rpm auf einem Photolack aufgebracht wurde, so daß mehrere Polystyrol(1700))-block-Poly([2-vinylpyridin•(HAuCl₄)_{0.5}](450))-Zweiblockcopolymermizellen vor der Ablösung des Photolacks und der Sauerstoffplasmabehandlung in der linearen Vertiefung übereinandergestapelt wurden. Figur 6 zeigt eine rasterkraftmikroskopische Aufnahme einer 20 nm breiten und 50 nm hohen Linie des in diesem Beispiel erhaltenen oberflächendekorierten Substrats.

### Beispiel 5

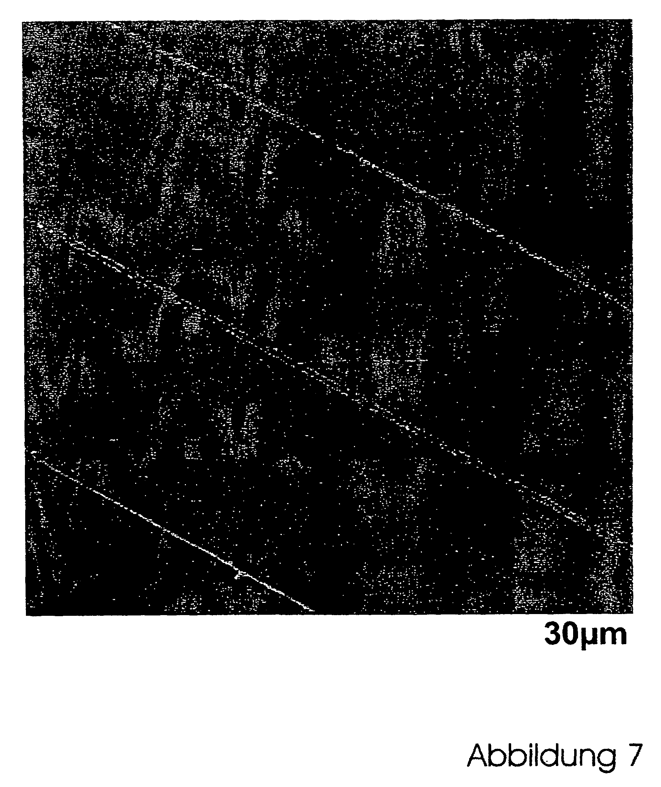

Ein Photolack wurde, wie in Beispiel 1 beschrieben, mit Linien unterschiedlicher Breite strukturiert (200nm, 2µm und 500nm) und anschließend der gleichen Vorgehensweise wie in Beispiel 1 unterzogen. Figur 7 zeigt eine rasterkraftmikroskopische Aufnahme 10 nm breiter und 100 µm langer Linien in unterschiedlichen Abständen zueinander.

### Beispiel 6

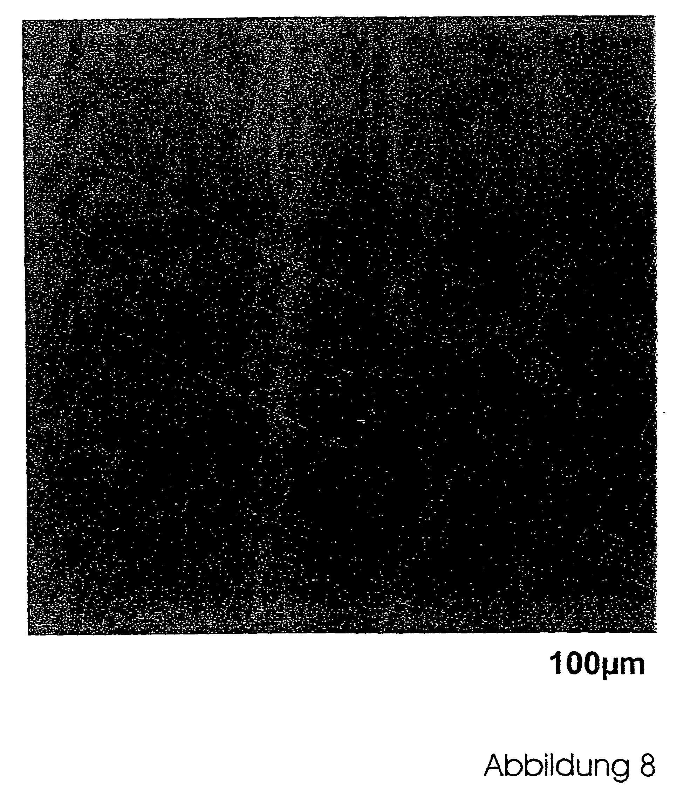

Ein Photolack wurde, wie in Beispiel 1 beschrieben, mit Linien unterschiedlicher Breite (200 nm, 2 µm und 500 nm) und mit 10 µm großen Quadraten strukturiert und anschließend der gleichen Vorgehensweise wie in Beispiel 1 unterzogen. Figur 8 zeigt eine rasterkraftmikroskopische Aufnahme 10 nm breiter und 100 µm langer Linien in unterschiedlichen Abständen zueinander und Quadrate mit einem Rahmen von 10 nm breiten Linien des in diesem Beispiel erhaltenen oberflächendekorierten Substrats.

## Patentansprüche

1. Verfahren zur Herstellung von im Nanometerbereich oberflächendekorierten Substraten, umfassend die Schritte:
(a) Aufbringen mindestens einer Photolackschicht mit einer vorbestimmten Tiefenstruktur auf mindestens eine Oberfläche des Substrats,
(b) Aufbringen eines durch Aufnehmen eines Polymers in einem geeigneten Lösungsmittel unter Bildung eines gelösten Kem-Schale-Polymersystems und Beladen von mindestens einem Teil der Polymerkerne mit einer oder mehreren, gleichen oder unterschiedlichen Metallverbindungen hergestellten Kern-Schale-Polymersystems auf das in Schritt (a) erhaltene Substrat, so daß die vorbestimmte Tiefenstruktur des Photolacks und/oder die durch die Photolackstruktur begrenzte Substratoberfläche benetzt werden,
(c) Entfemen der Phototackschicht von der Substratoberfläche und
(d) Entfernen des das Kern-Schale-Polymersystem aufbauenden Polymers unter Erzeugung von Metallclustern und/oder Clustern von Metallverbindungen auf der Substratoberfläche in Abhängigkeit von der in Schritt (a) vorbestimmten Tiefenstruktur.

2. Verfahren nach Anspruch 1, wobei das Substrat aus Edelmetallen, oxidischen Gläsern, mono- oder multikristallinen Substraten, Halbleitern, Metallen mit oder ohne passivierter Oberfläche oder Isolatoren ausgewählt ist.

3. Verfahren nach Anspruch 2, wobei das Substrat aus Si, SiO₂, Pt, Au, GaAs, In_{y}GaAs, AlₓGaAs, Ge, SiₓN_{y}, SiₓGaAs, InP, InPSi, GalnAsP, Glas, Graphit, Diamant, Glimmer, SrTiO₃ oder deren dotierte Modifikationen ausgewählt ist.

4. Verfahren nach einem der Ansprüche 1 bis 3, wobei das Polymer aus Blockcopolymeren, Pfropfcopolymeren, Miktoarmsternpolymeren, Sternpolymeren mit unterschiedlichen Armen, dentritischen Polymeren, Mikrogelteilchen, Sternblockpolymeren, Blocksternpolymeren und Kern-Schale-Latexpolymeren ausgewählt ist.

5. Verfahren nach Anspruch 4, wobei das Polymer Polystyrol-b-polyethylenoxid,Polystyrol-b-poly(2-vinylpyridin),Polystyrol-b-poly(4-vinylpyridin)oder ein Gemisch davon ist.

6. Verfahren nach einem der Ansprüche 1 bis 5, wobei die Metallverbindung aus Verbindungen von Au, Pt, Pd, Ag, In, Fe, Zr, Al, Co, Ni, Ga, Sn, Zn, Ti, Si und Ge in den entsprechenden Oxidationsstufen oder Gemischen davon ausgewählt ist.

7. Verfahren nach Anspruch 6, wobei die Metallverbindung aus HAuCl₄, MeAuCl₄, wobei Me ein Alkalimetall bedeutet, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, wobei R einen geradkettigen oder verzweigtkettigen C₁-C₈-Alkylrest bedeutet, Ferrocen, Zeisesalz und SnBu₃H oder Gemischen davon ausgewählt ist.

8. Verfahren nach Anspruch 7, wobei die Metallverbindung HAuCl₄ ist.

9. Verfahren nach einem der Ansprüche 1 bis 8, worin in Schritt (b) das Aufbringen durch ein Spinschleuderverfahren aus verdünnter Lösung durchgeführt wird.

10. Verfahren nach einem der Ansprüche 1 bis 9, wobei in Schritt (c) die Phototackschicht von der Substratoberfläche mittels eines Lösungsmittels abgelöst wird.

11. Verfahren nach einem der Ansprüche 1 bis 10, wobei in Schritt (d) das Polymer mittels eines Pyrolyse-, Ätz-, Reduktions- oder Oxidationsprozesses entfernt wird.

12. Verfahren nach Anspruch 11, wobei das Polymer mittels eines Sauerstoffplasmas entfernt wird.

13. Verfahren nach einem der Ansprüche 1 bis 12, worin die Schritte (c) und (d) gleichzeitig durchgeführt weden.

14. Im Nanometerbereich oberflächendekoriertes Substrat, weiches auf mindestens einer Oberfläche Strukturen aus 1 bis 30 nm großen und/oder 1 bis 30 nm breiten Linien aufweist, die aus Clustern von Metallatomen und/oder Metallverbindungen aufgebaut sind, die ein Aspektverhältnis von größer als 50 aufweisen.

15. Substrat nach Anspruch 14, wobei die Cluster aus gleichen oder unterschiedlichen Metattatomen und/oder Metalloxiden bestehen.

16. Substrat nach Anspruch 15, wobei die Cluster aus Goldatomen bestehen.

17. Substrat nach Anspruch 15, wobei die Cluster aus Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/Zr-O₂, Pt/Graphit oder Pt/Al₂O₃ bestehen.

18. Substrat nach einem der Ansprüche 14 bis 17, wobei das Substrat aus Pt, Au, GaAs, In_{y}GaAs, AlₓGaAs, Si, SiO₂, Ge, SiₓN_{y}, SiₓGaAs, inP, InPSi, GalnAsP, Glas, Graphit, Diamant, Glimmer, SrTiO₃ oder deren dotierte Modifikationen ausgewählt ist.

19. Verwendung des im Nanometerbereich oberflächendekorierten Substrats nach einem der Ansprüche 14 bis 18 als Master zur Erzeugung eines Stempels, weicher für den weiteren Übertrag der Nanostrukturen eingesetzt werden kann, als Maske zum Übertrag in ein unterliegendes Substrat oder einen Film durch Trocken- oder Naßätzprozesse, als Ausgangspunkte für die Verankerung weitererer Moleküle, Cluster und Atome an die einzelnen Nanocluster, als Streuzentren von elektromagnetischen Wellen und zur Modulierung von Brechungsindices, Leitfähigkeits- und Magnetismuseigenschaften von Substraten sowie als Maske zum Übertrag der Struktur in eine optisch aktive Halbleiterschichtstruktur durch Reaktives lonenätzen (RIE) oder lonen-Abtrag.

## Claims

1. Method for the production of nanometre range surface-decorated substrates, comprising the steps:
(a) application of at least one photoresist layer having a predetermined depth structure to at least one surface of the substrate,
(b) application of a core-shell polymer system, prepared by taking up a polymer in a suitable solvent with formation of a dissolved core-shell polymer system and loading of at least part of the polymer cores with one or more, identical or different metal compounds, to the substrate obtained in step (a), so that the predetermined depth structure of the photoresist and/or the substrate surface limited by the photoresist structure are wetted,
(c) removal of the photoresist layer from substrate surface and
(d) removal of the polymer constituting the core-shell polymer system with production of metal clusters and/or clusters of metal compounds on the substrate surface depending on the depth structure predetermined in step (a).

2. Method according to Claim 1, the substrate being selected from noble metals, oxidized glasses, mono- or polycrystalline substrates, semiconductors, metals with or without passivated surface or insulators.

3. Method according to Claim 2, the substrate being selected from Si, SiO₂, Pt, Au, GaAs, In_{y}GaAs, AlₓGaAs, Ge, SiₓN_{y}, SiₓGaAs, InP, InPSi, GaInAsP, glass, graphite, diamond, mica, SrTiO₃ or the doped modifications thereof.

4. Method according to any one of Claims 1 to 3, the polymer being selected from block copolymers, graft copolymers, microarm star polymers, star polymers having different arms, dentritic polymers, microgel particles, star block polymers, block star polymers and core-shell latex polymers.

5. Method according to Claim 4, the polymer being polystyrene-b-polyethylene oxide, polystyrene-b-poly(2-vinylpyridine), polystyrene-b-poly(4-vinylpyridine) or a mixture thereof.

6. Method according to any one of Claims 1 to 5, the metal compound being selected from compounds Au, Pt, Pd, Ag, In, Fe, Zr, Al, Co, Ni, Ga, Sn, Zn, Ti, Si and Ge in the corresponding oxidation states or mixtures thereof.

7. Method according to Claim 6, the metal compound being selected from HAuCl₄, MeAuCl₄, in which Me denotes an alkali metal, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, in which R denotes a straight-chain or branched C₁-C₈-alkyl radical, ferrocene, Zeise's salt and SnBu₃H or mixtures thereof.

8. Method according to Claim 7, the metal compound being HAuCl₄.

9. Method according to any one of Claims 1 to 8, in which, in step (b), the application is carried out by a spin coating method from dilute solution.

10. Method according to any one of Claims 1 to 9, in step (c) the photoresist layer being stripped off the substrate surface by means of a solvent.

11. Method according to any one of Claims 1 to 10, in step (d) the polymer being removed by means of a pyrolysis, etching, reduction or oxidation process.

12. Method according to Claim 11, the polymer being removed by means of an oxygen plasma.

13. Method according to any one of Claims 1 to 12, in which the steps (c) and (d) are carried out simultaneously.

14. Nanometre-range surface-decorated substrate which has, on at least one surface, structures comprising 1 to 30 nm long and/or 1 to 30 nm wide lines which are composed of clusters of metal atoms and/or metal compounds, which have an aspect ratio greater than 50.

15. Substrate according to Claim 14, the clusters consisting of identical or different metal atoms and/or metal oxides.

16. Substrate according to Claim 15, the clusters consisting of gold atoms.

17. Substrate according to Claim 15, the clusters consisting of Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/graphite or Pt/Al₂O₃.

18. Substrate according to any one of Claims 14 to 17, the substrate being selected from Pt, Au, GaAs, In_{y}GaAs, AlₓGaAs, Si, SiO₂, Ge, SiₓN_{y}, SiₓGaAs, InP, InPSi, GaInAsP, glass, graphite, diamond, mica, SrTiO₃ or doped modifications thereof.

19. Use of the nanometre-range surface-decorated substrate according to any one of Claims 14 to 18 as a master for the production of a stamp which can be used for further transfer of nanostructures, as a mask for transfer to an underlying substrate or a film by dry or wet etching processes, as starting points for the anchoring of further molecules, clusters and atoms to the individual nanoclusters, as scattering centres of electromagnetic waves and for the modulation of refractive indices, conductivity and magnetism properties of the substrates and as a mask for transferring the structure to an optically active semiconductor layer structure by reactive ion etching (RIE) or ion ablation.

## Revendications

1. Procédé pour produire des substrats de l'ordre du nanomètre, à surfaces décorées, comprenant les étapes de :
(a) l'application d'au moins une couche de résine photosensible présentant une structure en creux prédéterminée sur au moins une surface du substrat,
(b) l'application d'un système de polymère à noyau produit par l'absorption d'un polymère dans un solvant app. prié formant un système de polymère à noyau dilué et le chargement d'au moins une partie des noyaux de polymères avec un ou plusieurs composés métalliques identiques ou différents, sur le substrat obtenu à l'étape (a) de sorte que la structure en creux prédéterminée de la résine photosensible et/ou la surface du substrat limitée par la structure de la résine photosensible soient mouillées,
(c) l'élimination de la couche de résine photosensible de la surface du substrat et
(d) l'élimination du polymère constituant le système de polymère à noyau en produisant des amas métalliques et/ou des amas de composés métalliques sur la surface du substrat, en fonction de la structure en creux prédéterminée à l'étape (a).

2. Procédé selon la revendication 1, dans lequel le substrat est choisi parmi les métaux précieux, les verres oxydés, les substrats mono- ou multi-cristallins, les semi-conducteurs, les métaux avec ou sans surface passivée ou les isolants.

3. Procédé selon la revendication 2, dans lequel le substrat est choisi parmi Si, SiO₂, Pt, Au, GaAs, In_{y}GaAs, AlₓGaAs, Ge, SiₓN_{y}, SiₓGaAs, InP, InPSI, GalnAsP, le verre, le graphite, le diamant, le mica, SrTiO₃ ou leurs modifications dopées.

4. Procédé selon l'une quelconque des revendications 1 à 3, dans lequel le polymère est choisi parmi les copolymères en bloc, les copolymères greffés, les polymères en étoile à micro-branches, les polymères en étoile avec différentes branches, les polymères dendritiques, les microparticules de gel, les polymères en bloc en étoile, les polymères en étoile en bloc, et les polymères latex à noyau.

5. Procédé selon la revendication 4, dans lequel le polymère est l'oxyde de polystyrène-b-polyéthylène, le polystyrène-b-poly(2-vinylpyridine), le polystyrène-b-poly(4-vinylpyridine) ou un mélange de ceux-ci.

6. Procédé selon l'une quelconque des revendications 1 à 5, dans lequel le composé métallique est choisi parmi les composés de Au, Pt, Pd, Ag, In, Fe, Zr, Al, Co, Ni, Ga, Sn, Zn, Ti, Si et Ge dans les étapes d'oxydation correspondantes ou leurs mélanges.

7. Procédé selon la revendication 6, dans lequel le composé métallique est choisi parmi HAuCl₄, MeAuCl₄, Me signifiant un métal alcalin, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, R étant un radical alkyle en C₁-C₈ à chaîne linéaire ou ramifiée, le ferrocène, le sel et SnBu3H ou leurs mélanges.

8. Procédé selon la revendication 7, dans lequel le composé métallique est HAuCl₄.

9. Procédé selon l'une quelconque des revendications 1 à 8, dans lequel à l'étape (b), l'application s'effectue par un procédé de rotation par centrifugation d'une solution diluée.

10. Procédé selon l'une quelconque des revendications 1 à 9, dans lequel à l'étape (c), la couche de résine photosensible de la surface du substrat est diluée au moyen d'un solvant.

11. Procédé selon l'une quelconque des revendications 1 à 10, dans lequel à l'étape (d), le polymère est éliminé au moyen d'une pyrolyse, d'un processus de gravure, de réduction ou d'oxydation.

12. Procédé selon la revendication 11, dans lequel le polymère est éliminé au moyen d'un plasma d'oxygène.

13. Procédé selon l'une quelconque des revendications 1 à 12, dans lequel les étapes (c) et (d) sont réalisées en même temps.

14. Substrat de l'ordre du nanomètre à surfaces décorées, qui présente sur au moins une surface, des structures de 1 à 30 nm de grandeur et/ou des lignes de 1 à 30 nm de largeur qui sont constituées d'amas d'atomes métalliques et/ou de composés métalliques présentant un rapport d'aspect supérieur à 50.

15. Substrat selon la revendication 14, dans lequel l'amas est constitué d'atomes métalliques et/ou d'oxydes métalliques identiques ou différents.

16. Substrat selon la revendication 15, dans lequel les amas sont constitués d'atomes d'or.

17. Substrat selon la revendication 15, dans lequel les amas sont constitués de Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/Zr-O₂, Pt/graphite ou Pt/Al₂O₃.

18. Substrat selon l'une quelconque des revendications 14 à 17, dans lequel le substrat est choisi parmi Pt, Au, GaAs, In_{y}GaAs, AlₓGaAs, Si, SiO₂, Ge, SiₓN_{y}, SiₓGaAs, InP, InPSI, GalnAsP, le verre, le graphite, le diamant, le mica, SrTiO₃ ou leurs modifications dopées.

19. Utilisation du substrat de l'ordre du nanomètre, à surfaces décorées selon l'une quelconque des revendications 14 à 18, comme matrice pour produire un tampon qui peut être utilisé pour le report ultérieur des nanostructures, comme masque pour le report dans un substrat sous-jacent ou un film par des procédés de gravure à sec ou mouillée, comme points de départ pour l'ancrage d'autres molécules, amas et atomes aux nano-amas individuels, comme centres de diffusion d'ondes électromagnétiques et pour la modulation des indices de réfraction, des propriétés de conduction et de magnétisme de substrats, ainsi que comme masque pour le report de la structure dans une structure à couche semi-conductrice active par gravure ionique réactive (GIR) ou enlèvement ionique de matière.
